(19) Europäisches Patentamt / European Patent Office / Office européen des brevets

(11) **EP 4 589 046 A1**

(12) **EUROPEAN PATENT APPLICATION**
published in accordance with Art. 153(4) EPC

(43) Date of publication:
**23.07.2025 Bulletin 2025/30**

(21) Application number: 23888544.6

(22) Date of filing: 30.10.2023

(51) International Patent Classification (IPC):
*C23C 14/14* [(2006.01)]    *C23C 14/20* [(2006.01)]
*H01M 4/64* [(2006.01)]    *H01M 4/66* [(2006.01)]

(52) Cooperative Patent Classification (CPC):
**C23C 14/14; C23C 14/20; H01M 4/64; H01M 4/66;**
Y02E 60/10

(86) International application number:
**PCT/JP2023/039052**

(87) International publication number:
**WO 2024/101196 (16.05.2024 Gazette 2024/20)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **10.11.2022 JP 2022180064**

(71) Applicant: **Toray Industries, Inc.**
**Tokyo 103-8666 (JP)**

(72) Inventors:
- **ARAI Takashi**
  **Tokyo 103-8666 (JP)**
- **NISHIMURA Dai**
  **Otsu-shi, Shiga 520-2141 (JP)**
- **ANDO Takashi**
  **Otsu-shi, Shiga 520-2141 (JP)**
- **FUJI Nobuo**
  **Kakogawa-shi, Hyogo 675-8558 (JP)**
- **TSUJI Teruaki**
  **Kakogawa-shi, Hyogo 675-8558 (JP)**

(74) Representative: **Kador & Partner Part mbB**
**Corneliusstraße 15**
**80469 München (DE)**

(54) **METALLIZED FILM FOR SECONDARY BATTERY POSITIVE ELECTRODE AND METHOD FOR PRODUCING SAME**

(57) The present invention provides a metalized film that has contact resistance lower than surface resistance even when a conductive thin film layer is formed on a resin surface, has excellent post-processing suitability, such as the transportability thereof without breaking, and also has excellent adhesion with a positive electrode active material. In the metallized film for a secondary battery positive electrode, an aluminum metal layer is formed on at least one surface of a resin film, and when the crystal orientation of a cross section of the aluminum metal layer is imaged by the ACOM-TEM method, the surface area of each of crystal regions respectively having <001>, <011>, and <111> orientations is 75% or less of the total surface area.

Figure 3

**Description**

TECHNICAL FIELD

The present invention relates to a metalized film for secondary batteries and to a method for the production thereof.

BACKGROUND ART

In recent years, portable digital devices such as smart-phones, tablets, cellular phones, notebook computers, digital cameras, digital video cameras, and portable game devices, portable apparatuses such as electric tools, electric bikes, and electric assisted bicycles, and new-generation automotive applications such as electric vehicles, hybrid vehicles, and plug-in hybrid vehicles have become more widespread. In addition, power generation from natural energy sources such as photovoltaic energy and wind energy is now deployed widely. Accordingly, there has been a growing demand for usage and storage of local electric energies and this in turn has heightened the need for enhanced batteries and energy storage systems. Under these circumstances, the demand for electrical storage elements such as batteries and capacitors is growing, and among them, lithium-ion batteries are particularly widespread.

In general, a lithium-ion battery has a configuration that includes a positive electrode formed by laying a positive electrode active material on a positive electrode current collector and a negative electrode formed by laying a negative electrode active material on a negative electrode current collector, with a secondary battery separator and an electrolyte interposed between them. Furthermore, in response to requirements for electric and electronic devices of smaller sizes and next-generation automobiles characterized by improved electric power consumption and extended mileage, there has been a growing demand for smaller and lighter batteries, and at the same time, there is also an increasing demand for batteries with higher output and higher power density that realize quick charge and discharge of large power.

In general, in order to achieve an increased gravimetric energy density, storage batteries mounted on vehicles are configured so that the positive and negative electrodes, which are in the form of sheets, are wound or stacked with a similarly sheet-like separator interposed between them, and these sheets of positive and negative electrodes are housed in a case. These sheet-like electrode plates have a structure in which a mixture layer containing an active material is laid on the surface of metal foil that serves as current collector.

Another way to realize a high power density is to reduce the resistance of the various materials incorporated in a storage battery (internal resistance of storage battery). In many cases, aluminum foil is used as current collector in storage batteries, but conventional aluminum foil-based current collectors typically contain oxide film, and it has been reported that the oxide film formed on the surface of the aluminum foil acts to increase the internal resistance. An increase in the internal resistance causes a voltage drop when high current charge or discharge is conducted, and this leads to a decline in the output of the storage batteries. Generally, a naturally formed oxide film, which acts as a strong insulator, with a thickness of about 5 to 10 nm is present on aluminum foil, but the aluminum surface can maintain a high conductivity. In a proposed explanation, this can be caused by current outflow through defect sites on the oxide film. There is another explanation based on quantum mechanics that proposes a tunneling phenomenon in which a particle can, with some probability, pass through a region that it normally would not have enough energy to surmount. Due to the tunneling effect, as two conductive bodies are brought closer to each other with an electrical insulator interposed in between, efficient electronic conduction starts when the distance between them comes to 10 nm or so. Thus, although the mechanism has not yet been clearly clarified, it is considered that the aluminum oxide film itself has strong influence on the internal resistance.

To suppress the rise in the contact resistance between the electrode and the active material, which acts to prevent an increase in the internal resistance caused by the oxide film, a good method is to form irregularities in the surface of the metal foil used in the electrode (for example, see Patent document 1). It is not clear whether the roughing of the aluminum surface serves to increase in the number of defect sites or to allow the tunneling effect to become more likely to occur as a result an increase in the number of protrusions formed, but it is certain that this approach is effective in reducing the contact resistance.

In order to increase the high power density while achieving both miniaturization and weight reduction, efforts have been made to produce electrodes and electrode current collectors in the form of thinner films, aiming to increase the volumetric energy density or increase the gravimetric energy density. However, if the metal foil in use as an electrode is made thinner in a simply manner to meet this purpose, it tends to lead to a problem of insufficient strength. Furthermore, if irregularities are enlarged in the surface of a metal foil sheet that has been thinned with the aim of reducing the contact resistance, it can further reduce the strength of the metal foil, which is undesirable. Therefore, it has been proposed to use, as a novel alternative to metal foils, a material composed mainly of a conductive thin film layer of metal or the like laid on the surface of a biaxially stretched polyester thin film, which has good mechanical properties and high thermal dimensional stability. If a current collecting function is imparted, this material can work as an electrode base (for example, see Patent documents 2 and 3).

# EP 4 589 046 A1

PRIOR ART DOCUMENTS

PATENT DOCUMENTS

Patent document 1: Japanese Unexamined Patent Publication (Kokai) No. 2008-160053
Patent document 2: Japanese Unexamined Patent Publication (Kokai) No. HEI 10-40919
Patent document 3: Japanese Patent No. 6211796

SUMMARY OF INVENTION

PROBLEMS TO BE SOLVED BY THE INVENTION

However, in a metalized film composed of a conductive thin film layer of metal or the like laid on the surface of a resin film such as a polyester thin film, the thickness of the metal layer is smaller than those metal foils that have been used conventionally, and as a result, the electrical resistance values, i.e., the surface resistance and contact resistance, of the metalized film become larger than those of the metal foils. On the other hand, as a conventional technique, there is a known method of roughening the metal surface, such as aluminum surface, in order to lower the contact resistance of the metal surface. However, the vacuum deposition technique and the like have been the common methods used for forming a conductive thin film layer of metal or the like on the surface of a resin film, but it is extremely difficult to roughen it by means of etching or the like because the deposited metal film formed by such a technique is extremely thin. Furthermore, if an attempt is made to prepare a resin film such as a polyester thin film with the surface roughened in advance and subsequently form a deposited metal layer on it, the resulting resin film is likely to tear easily, making it difficult to convey the materials during vacuum deposition and in the subsequent production steps for coating, drying, and pressing of a positive electrode active material spread on the metalized film. Thus, there have been problems such as temperature rise occurring inside the storage battery due to increased resistances and unsuitability for use under the conditions of high-power, rapid charge-discharge operations.

In view of the facts described above, the main object of the present invention is to provide a metalized film that is characterized by having a lower contact resistance compared to its surface resistance, having good properties suitable for subsequent processing steps such as high transportability without breakage, and additionally having high adhesiveness to positive electrode active materials, even when having a conductive thin film layer laid on the resin surface.

MEANS OF SOLVING THE PROBLEMS

In view of the above problems, the present inventors conducted intensive studies and as a result, succeeded in developing a metalized film that is characterized by having a lower contact resistance compared to its surface resistance and having high adhesiveness to electrode active materials and in developing a method for the production thereof, which are realized by using the vacuum deposition technique in order to control the surface profile of the deposited film, as well as its crystal size and crystal orientation. It was also found that an electrical storage element and an electrical storage module having good rate properties and cycling properties can be produced by using a positive electrode current collector made from such a metalized film.

More specifically, the present invention relates to:

a metalized film for secondary battery positive electrodes that includes a resin film and an aluminum metal layer laid on at least one surface thereof, wherein the aluminum metal layer has a cross section characterized by having crystal orientation such that crystal regions oriented in any of <001>, <011>, and <111> directions account for not more than 75% of the total area as measured by the ACOM-TEM method;

a metalized film for secondary battery positive electrodes as set forth above, wherein the surface of the aluminum metal layer that is not in contact with the resin film has a surface roughness Ra of 15 to 60 nm;

a metalized film for secondary battery positive electrodes as set forth above, wherein the aluminum metal layer has a thickness of 0.5 to 3.0 $\mu$m;

a metalized film for secondary battery positive electrodes as set forth above, wherein the average crystal size along the line that is parallel to the outermost surface of the aluminum metal layer not in contact with the resin film and is located at a depth of 300 nm measured from the top position of the outermost surface of the aluminum metal layer toward the resin film is 300 nm or less; and

a metalized film for secondary battery positive electrodes as set forth above, wherein the surface resistivity A ($\Omega/\square$) measured by the four terminal method on the surface of the aluminum metal layer and the contact resistance B (m$\Omega$) is

within the range specified by the formula given below:

$$0.05 \leq B / (A \times 1{,}000) \leq 0.5.$$

In addition, the present invention relates to a method for producing the aforementioned metalized film for secondary battery positive electrodes including a step for depositing vaporized aluminum to form a film on a resin film by means of a vacuum deposition process wherein an aluminum material serving as deposition source is heated and vaporized by at least one selected from the group consisting of resistance heating, induction heating, and electron beam heating while introducing argon gas during the process.

The present invention also relates to an electrical storage element including a metalized film for secondary battery positive electrodes as set forth above, and an electrical storage module including an electrical storage element as set forth above.

ADVANTAGEOUS EFFECTS OF THE INVENTION

According to the present invention, it is possible to obtain a metalized film that is characterized by having a lower contact resistance compared to its surface resistance and having high adhesiveness to electrode active materials, as well as a method for the production thereof, which are realized by means of a vacuum deposition technique designed to control the surface profile of the deposited film, as well as its crystal size and crystal orientation. In addition, an electrical storage element and an electrical storage module having good rate properties and cycling properties can be produced by using a positive electrode current collector made of the above metalized film.

BRIEF DESCRIPTION OF THE DRAWINGS

[Fig. 1] This is a schematic cross-sectional diagram of the metalized film according to the present invention.

[Fig. 2] This is a schematic cross-sectional diagram of the metalized film according to the present invention.

[Fig. 3] This is a schematic cross-sectional diagram of the metalized film according to the present invention.

[Fig. 4] This is a schematic diagram illustrating the definitions of the outermost surface and the top position and their relationship with the surface roughness in an aluminum metal layer used for the present invention.

[Fig. 5] This is a scanning electron microscope (SEM) photograph of the surface of an aluminum metal layer (with a thickness of 1.48 $\mu$m) having large, dense crystal grains grown by using an induction heating type deposition source with a carbon crucible.

[Fig. 6] This is a SEM photograph of a cross section of an aluminum metal layer (with a thickness of 1.48 $\mu$m) having large, dense crystal grains grown by using an induction heating type deposition source with a carbon crucible.

[Fig. 7] This is an SEM photograph of the surface of an aluminum metal layer (with a thickness of 1.12 $\mu$m) grown by using a boat-based heating method in which an aluminum metal wire is continuously supplied to a resistance heated boat.

[Fig. 8] This is a transmission electron microscope (TEM) photograph of a cross section of an aluminum metal layer (with a thickness of 1.06 $\mu$m) formed by using a induction heating type deposition source with a carbon crucible.

[Fig. 9] This is a TEM photograph of a cross section of an aluminum metal layer (with a thickness of 1.12 $\mu$m) formed by using a boat-based heating method in which an aluminum metal wire is continuously supplied to a resistance heated boat.

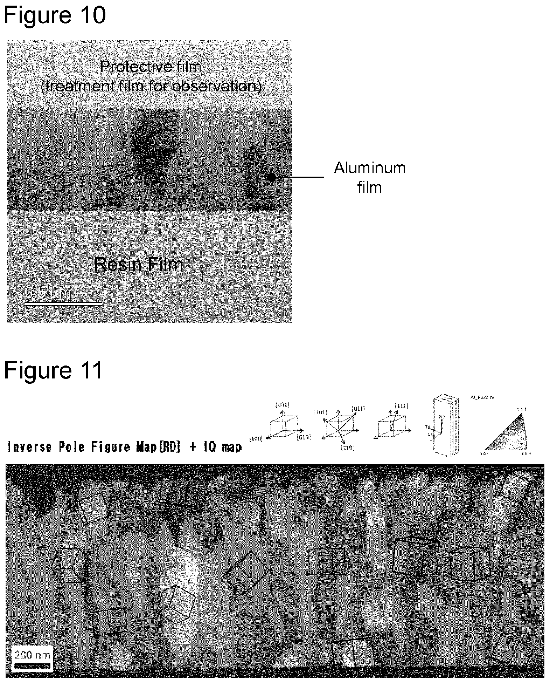

[Fig. 10] This is a TEM photograph of a cross section of an aluminum metal layer (with a thickness of 0.96 $\mu$m) formed by using a boat-based heating method in which an aluminum metal wire is continuously supplied to a resistance heated boat.

[Fig. 11] This is an ACOM-TEM photograph of a cross section of an aluminum metal layer (with a thickness of 1.06 $\mu$m) formed by using an induction heating type deposition source with a carbon crucible.

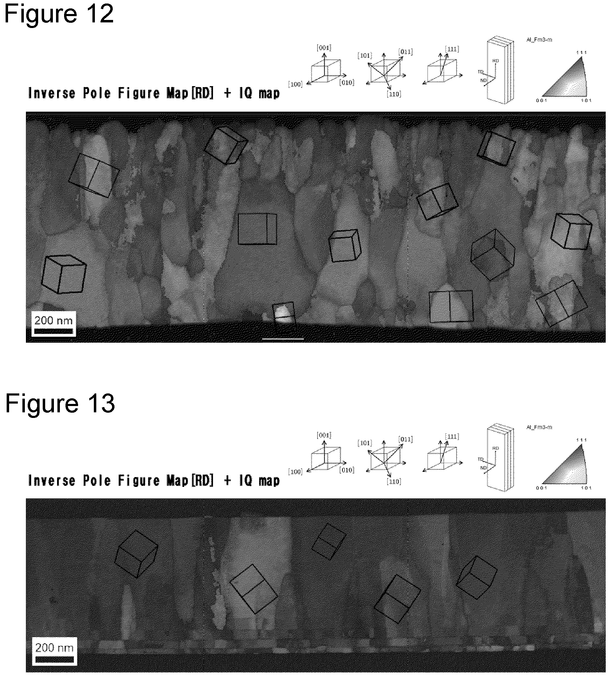

[Fig. 12] This is an ACOM-TEM photograph of a cross section of an aluminum metal layer (with a film thickness of 1.12 $\mu$m) formed by using a boat-based heating method in which an aluminum metal wire is continuously supplied to a resistance heated boat.

[Fig. 13] This is an ACOM-TEM photograph of a cross section of an aluminum metal layer (with a film thickness of 0.96 $\mu$m) formed by using a boat-based heating method in which an aluminum metal wire is continuously supplied to a resistance heated boat.

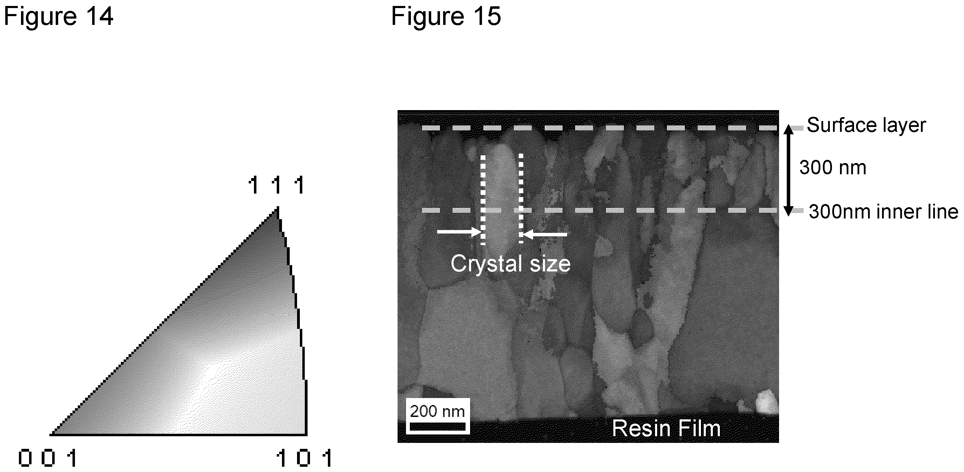

[Fig. 14] This is a color-coded diagram showing crystal orientations of aluminum metal.

[Fig. 15] This is a diagram supplementarily explaining the method for calculating the sizes of aluminum metal crystals from a cross-sectional ACOM-TEM photograph.

## DESCRIPTION OF PREFERRED EMBODIMENTS

The invention is described in more detail below.

<Metalized film>

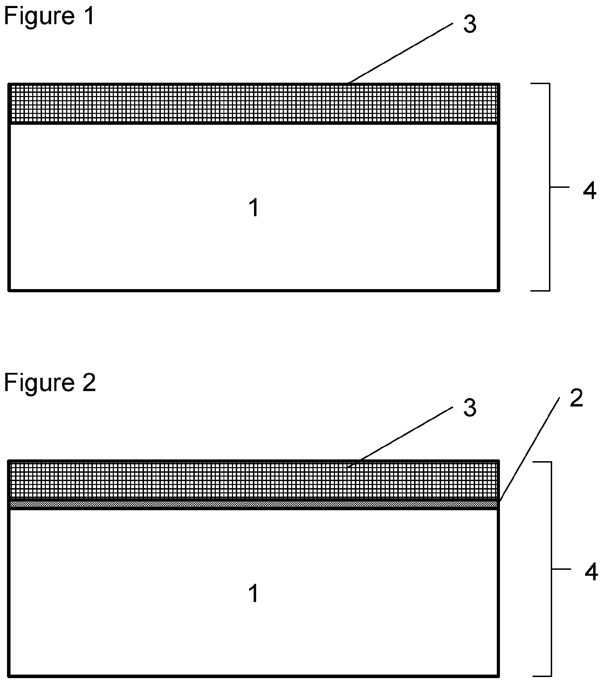

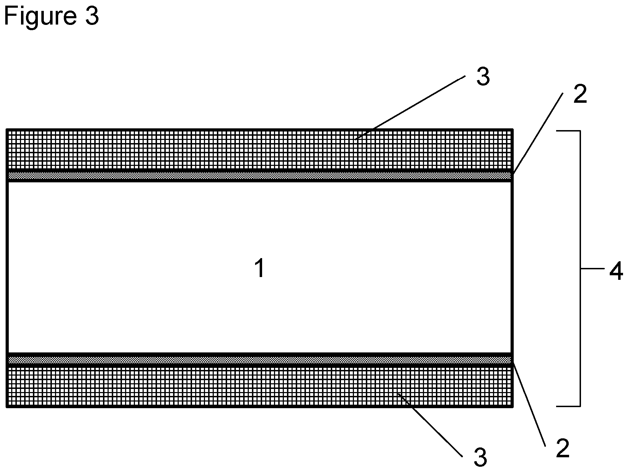

The metalized film 4 for secondary battery positive electrodes according to the present invention has an aluminum metal layer 3 on one or both surfaces of a resin film 1 (Fig. 1, Fig. 2, and Fig. 3).

<Aluminum metal layer>

For the present invention, the aluminum metal layer 3 is one layer or a group of two or more stacked layers of aluminum metal each containing aluminum as the main component. The main component means the component that accounts for more than 80 at% of the entire layer, which accounts for 100 at%.

For the present invention, it is preferable for the aluminum metal layer 3 to have a thickness of 0.5 $\mu$m or more and 3.0 $\mu$m or less, more preferably 0.7 $\mu$m or more and 2.5 $\mu$m or less. In the case where aluminum metal layers are formed on both surfaces of the resin film, it is preferable for each of the layers to have a thickness in the above range.

For use in secondary battery electrodes, it is preferable for both the surface resistance and contact resistance to be as low as possible because when they are high, they can work as internal resistances in the battery to cause heat generation. In the case of using a current collector formed by applying an active material on a metalized film and pressing them to increase the packing density, the surface resistance affects the current diffusion and uniformity in the plane direction and accordingly, it is preferable for the metal film to have a surface resistance of 0.15 $\Omega/\square$ or less, more preferably 0.05 $\Omega/\square$ or less.

Furthermore, the contact resistance of the surface of the metal layer of the metalized film also has an influence on the electron transfer between the metalized film and the active material layer formed on its surface. To determine this contact resistance, the metalized film 4 is put on a 10 mm thick piece of NR sponge rubber with the aluminum metal layer 3 facing upward, and two 25 mm $\times$ 25 mm gold plated copper plates are placed with a 1 mm gap between them, followed by laying a 500 g weight on each copper plate and measuring the resistance value between these two copper plates. To prevent an increase in the internal resistance, it is preferable for the metal film to have a contact resistance of 30 m$\Omega$ or less, more preferably 20 m$\Omega$ or less.

Meanwhile, it is necessary for the metalized film to be thin in order to increase its volumetric energy density, and it is necessary for the metalized film to be light in order to increase its gravimetric energy density. Therefore, simply making the metal film thicker is undesirable. Considering the electrical resistance of the electrode, it is preferable for the aluminum metal layer to have a thickness of 0.7 $\mu$m or more. If it is 1.0 $\mu$m or more, the resistance will be even lower and serve to prevent an increase in the internal resistance. On the other hand, in order to realize an increase in volumetric energy density and gravimetric energy density, it is necessary to use a thinner electrode base and to reduce the use of heavy metal components. Therefore, it is preferable for the aluminum metal layer to have a thickness of 3.0 $\mu$m or less, more preferably 2.5 $\mu$m or less.

In general, there is a correlation between the thickness of a metal film and its surface resistance or contact resistance, and furthermore, a correlation exists also between the surface resistance and the contact resistance. An increase in the thickness of a metal film leads to a decrease in the surface resistance and also to a decrease in the interfacial resistance. It should be noted that the contact resistance value referred to herein includes both the contact resistance between the two electrode areas, each measuring 25 mm $\times$ 25 mm, and the film resistance (surface resistance) between the two electrodes. Therefore, the ratio between the contact resistance value and the surface resistance value, i.e., [contact resistance value] / [surface resistance value], can indicate a value that is less influenced by the surface resistance. Furthermore, with a decrease in the value represented by the formula given below, which shows the ratio between the surface resistance A ($\Omega/\square$) and the contact resistance B (m$\Omega$), the contact resistance decreases relative to the surface resistance value or the thickness of the metal film, which means that a lower contact resistance is realized even though a thinner or lighter metal film. From the above viewpoint, the value given by the following formula is preferably 0.5 or less, more preferably 0.4 or less, still more preferably 0.3 or less, and particularly preferably 0.2 or less. On the other hand, there are no particular limitations on the lower limit of the value given by the following formula, but it is preferably 0.05 or more.

Formula: (contact resistance B) / (surface resistance A $\times$ 1,000)

In regard to the aluminum metal layer 3 used for the present invention, the present inventors made extensive study and succeeded in forming a resin film laid with an aluminum metal layer that has good electrical resistance properties and exhibits good contact resistance properties in comparison with the surface resistance and metal film thickness, which is realized by controlling the structure and crystal growth of the aluminum metal layer as described below. As a result, a metalized film for secondary battery positive electrodes that is characterized by being thinner and lighter and having better electrical resistance properties was produced successfully.

Specifically, the vacuum deposition step performed here is designed to control the aluminum metal layer formation so that the resulting aluminum crystals are not oriented uniformly. In addition, the crystal growth in the metal film is also controlled properly so that they are not oriented in a particular direction extremely preferentially, but crystals oriented in the <001>, <011>, and <111> directions coexist in a properly balanced ratio. Furthermore, aluminum crystals of controlled sizes are grown on the outermost surface of the aluminum metal layer to allow the surface to have large irregularities. This serves not only to realize good resistance properties as described above, but also to ensure strong adhesion to the active material layer to be formed by coating and pressing in subsequent steps as well as high conveyability and scratch resistance in the roll-to-roll setup used. As a result, this serves to prevent coarse portions from being formed near the surface of the aluminum metal layer when aluminum crystals are grown large up to the outermost surface of the metal film. If the aluminum metal layer 3 is formed in this manner, it becomes possible to ensure a characteristic that the contact resistance is small relative to the surface resistance.

With the aim of creating an aluminum metal layer 3 having a structure in which a decreased contact resistance is realized by controlling the crystal growth in the metal film, the present inventors focused on the orientation and crystal size of the aluminum crystals in the aluminum metal layer and conducted an in-depth investigation using the ACOM (automated crystal orientation mapping)-TEM method. The ACOM-TEM method is a technique designed to analyze the orientation distribution in a crystalline sample based on electron diffraction measured by TEM. An electron diffraction pattern is observed at different points by scanning the sample with an electron beam probe to provide crystal information with high spatial resolution. Compared to other methods such as SEM-EBSD (electron backscatter diffraction pattern) analysis, this technique can acquire information from smaller crystal grains. Accordingly, the present inventors thought that this could be suitable for analyzing the structure and orientation in a thin crystalline film, such as the aluminum metal layer used for the present invention, and applied it to their investigation. An overview of the analysis and evaluation procedures performed for the aluminum metal layer using the ACOM-TEM method is described below.

First, to observe a cross section of the aluminum metal layer in a metalized film for use as a positive electrode, an ultrathin section sample is prepared, for example, by using a specialized pretreatment technique such as the FIB (focused ion beam) method. Then, the ultrathin section sample prepared above is observed under a TEM, followed by identifying the crystal orientation, crystal angle, and crystal size by the ACOM-TEM method. As for the crystal orientation analysis, aluminum crystals present within the observation/imaging field of view can be classified into <001>, <011>, and <111> oriented crystals, which are representative orientation directions of aluminum, and displayed in different colors accordingly. Furthermore, in the resulting crystal orientation map, those aluminum crystals whose orientation axes deviate by 30° or less are regarded as being oriented in the same orientation and categorized into one of the three types described above, thereby allowing calculation of the percentage of aluminum crystals in each orientation category.

A preferred embodiment of the metalized film for secondary battery positive electrodes according to the present invention is that the aluminum crystals in the aluminum metal layer 3 are not biasedly oriented in any of the <001>, <011>, and <111> directions Thus, aluminum crystals of different orientations along different orientation axes grow large while maintaining close contact with each other during film formation. More specifically, the metalized film for secondary battery positive electrodes includes a resin film and an aluminum metal layer laid on at least one surface thereof, wherein the aluminum metal layer has a cross section in which crystals are oriented in such a manner that crystal regions oriented in any of <001>, <011>, and <111> directions account for 70% or less, more preferably 65% or less, of the total area as observed by the ACOM-TEM method.

For reference, aluminum has a cubic crystal system and therefore, when aluminum is in powder form with random orientation, the <111> oriented crystals account for the largest proportion. On the other hand, in the case of rolled aluminum foil, which is most widely used as positive electrode for secondary batteries, the degree of consolidation increases in the rolling step to cause an increase in the degree of crystal orientation, thereby leading to weakening of the diagonal <111> orientation while causing the <011> orientation to become extremely prevalent.

In regard to surface features, the aluminum metal layer 3, which has a reduced contact resistance, improved workability, and enhanced adhesion with the active material layer, which are achieved by controlling the growth of aluminum metal crystals in the metal film, preferably has a characteristic that the surface of the aluminum metal layer 3 that is not in contact with the resin film 1 has a surface roughness Ra of 15 nm or more and 60 nm or less, more preferably 20 nm or more and 55 nm or less. The contact resistance tends to decrease when the aluminum surface is sufficiently roughened to allow the irregularities to have a certain level of height, and therefore, a larger surface roughness Ra tends to be more preferable. However, if the surface roughness Ra is too large, the density in the vicinity of the outermost surface of the thin aluminum metal layer 3 can decrease and the crystalline interface can become relatively large. This may lead to breakage of the metal film when stress is applied to the metal film during conveyance etc. and therefore, it is preferably 60 nm or less.

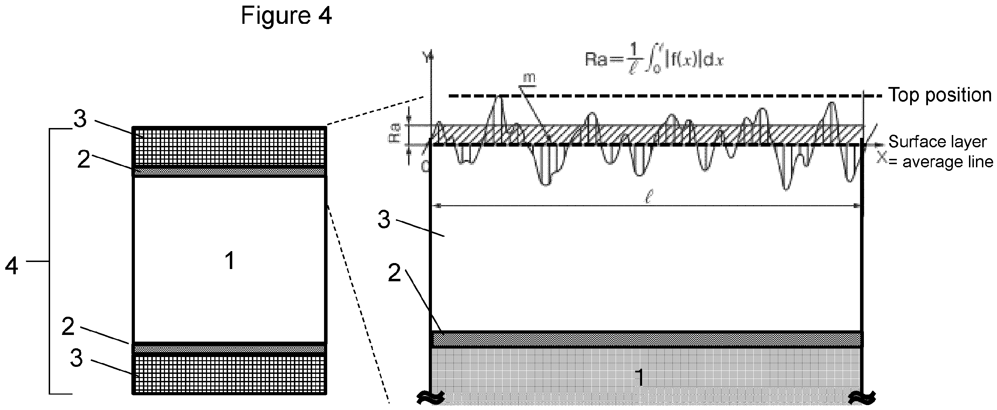

Furthermore, if aluminum crystals of a controlled size are grown on the outermost surface of the aluminum metal layer to allow the irregularities in the surface to be such that a surface roughness in the aforementioned preferable range is ensured, it serves not only to realize good resistance properties as described above, but also to ensure strong adhesion to the active material layer to be formed by coating and pressing in subsequent steps as well as high conveyability and scratch resistance, which is required to prevent the resistance properties from being declined by generation of flaws, in the roll-to-roll coating machine. Accordingly, the crystal grain size near the outermost surface of the aluminum metal layer will become excessively large to cause a decrease in density if aluminum crystals are grown large from the resin film side to the outermost surface side of the aluminum metal film. Therefore, it is better to control the aluminum crystal size in the thickness direction of the aluminum metal layer so that slightly smaller aluminum crystals are densely present near the surface side. More specifically, the average crystal size along the line that is parallel to the average line and is located at a depth of 300 nm from the top position of the outermost surface of the aluminum metal layer toward the interior of film is preferably 300 nm or less. As shown in Fig. 4, the "outermost surface" is the surface roughness curve of the aluminum metal layer and the "top position" refers to the highest point in the surface roughness curve. The "average line" is defined as the average line of the surface roughness curve specified in JIS B0601 (2013 edition).

If the surface temperature of the base, namely, the resin film, in the deposition step is raised as a means of controlling the crystal structure and orientation in the aluminum metal layer 3 as well as the surface structure of its outermost surface, it works to allow columnar crystals to grow dense while ensuring the coexistence of aluminum crystals orientated in the three directions instead of being oriented preferentially in one particular direction, thereby achieving a dense film.

However, in the case where a resin film is used as the base, it will melt and break if the base temperature is increased. If it is produced without special elaboration, it will be impossible to raise the base temperature sufficiently, and the metal grains in the aluminum metal layered film produced by the vacuum deposition method will end up as columnar crystals with large gaps in between.

For the present invention, even when the base is a resin film, columnar crystals were grown large and dense successfully in the aluminum metal layer, thereby forming large crystal grains, as a result of introducing argon gas during the increase of the surface temperature of the base and appropriately controlling the degree of vacuum during the deposition step. In addition, this also allowed the crystal size and density both in the interior (the film side) and in the surface region of the aluminum metal layer to be controlled successfully so that the average crystal size along the line that was parallel to the outermost surface of the aluminum metal layer and was located at a depth of 300 nm from the outermost surface of the aluminum metal layer toward the interior of the film was 300 nm or less. The formation of an aluminum metal layer in this manner also successfully served to form proper irregularities in the surface of the aluminum metal layer. If the heat output of the deposition source is increased while forcibly cooling the resin film from the back face, it becomes possible to heat only the vicinity of the surface region of the resin film that is exposed toward the deposition source, thus enabling the growth of large, dense columnar crystals. Here, the degree of vacuum in the deposition step is preferably controlled in the range of $9.0 \times 10^{-3}$ Pa or more and $2 \times 10^{-2}$ Pa or less, more preferably $9.0 \times 10^{-3}$ Pa or more and $1 \times 10^{-2}$ Pa or less.

In the case of a general aluminum vacuum deposition process that is intended to form a relatively thin aluminum metal layer such as aluminum deposited gas barrier film for food packaging, it is common to employ the boat heating method in which an aluminum metal wire is continuously supplied to a resistance heated boat. However, when an aluminum metal layer is formed by this method, the resulting aluminum crystals tend to be oriented preferentially in the <111> direction.

Meanwhile, it is preferable to use a deposition source with the highest possible heat output to allow the base surface temperature to be increased easily, thereby making it possible to finish the film formation step in a short time. From this point of view, it is preferable to adopt a deposition source with a large heat output, such as an induction heating type one using a carbon crucible or an electron beam heating type one, in order to ensure a large heat output from the deposition source and growth of crystal grains to a large size and a high density. However, if it is performed without special elaboration, the resin film will melt when heat is applied, and therefore, it is preferable to forcibly cool the resin film from the back face to a temperature just below its melting point, thereby allowing columnar crystals to grow large and dense in the aluminum metal layer. From the perspective of thermal effects on the resin film, it is preferable to adopt the boat-based resistance heating type deposition method. In addition, the introduction of argon gas in the deposition step can serve to form irregularities in the surface of the aluminum metal layer.

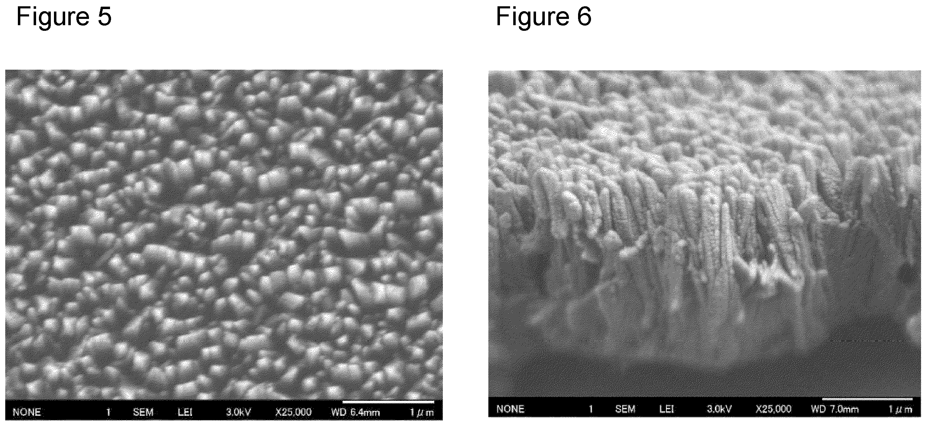

Fig. 5 and Fig. 6 show SEM photographs of the surface and a cross section of an aluminum metal layer that is formed by adopting a resin film (polyethylene terephthalate (PET) film) having a surface roughness Ra of 38 nm and growing crystal grains large and dense thereon by using an induction heating type deposition source having a carbon crucible with a high heat output. Fig. 5 gives an SEM photograph of the surface of an aluminum metal layer with a thickness of 1.48 μm, and Fig. 6 gives an SEM photograph of a cross section of an aluminum metal layer with a thickness of 1.48 μm. From Fig. 5 and Fig. 6, it can be seen that irregularities of appropriate size are present on the surface of the aluminum metal layer as a result of growing crystal grains to a large size. Here, the surface roughness Ra was 52 nm in Fig. 5. From the cross-sectional SEM photograph given in Fig. 6, furthermore, it can be seen that the aluminum metal layer contains columnar crystals, and each protrusion from the rough surface of the aluminum metal layer corresponds to a single columnar crystal. From this, it is inferred that larger protrusions from the rough surface of the aluminum metal layer indicate that larger and denser columnar crystals exist.

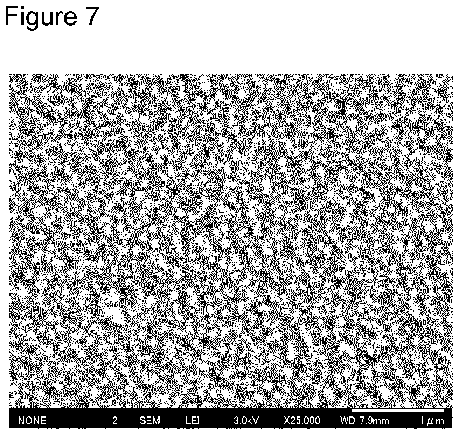

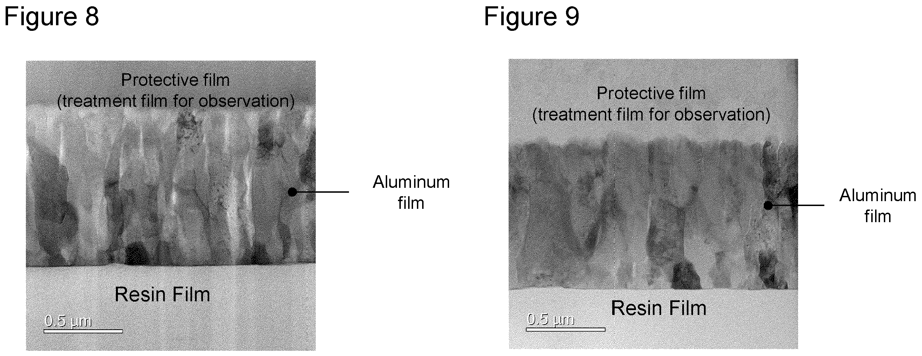

On the other hand, Fig. 7 and Fig. 8 show SEM photographs of the surface of an aluminum metal layer grown by using a boat-based heating method in which an aluminum metal wire is continuously supplied to a resistance heated boat. Fig. 7 shows aluminum crystals on an aluminum metal layer with a thickness of 1.02 $\mu$m whose growth was controlled by introducing argon gas as proposed for the present invention, and precisely controlling the degree of vacuum, and as seen in the surface SEM photograph, proper irregularities were formed with a surface roughness Ra of 34 nm. To produce a metal film having large, dense crystal grains, it is necessary to expose it to a deposition source, used as the heat source, for a certain period of time, and hence, a considerable deposition time is required. Accordingly, it is preferable for the aluminum metal layer to have a thickness of 0.5 $\mu$m or more, more preferably 0.7 $\mu$m or more, and particularly preferably 1.0 $\mu$m or more.

<Method for producing aluminum metal layer>

As a film formation method for forming the aluminum metal layer 3, it is preferable to adopt the vacuum deposition method so that a metal film can be formed on a thin resin film without the use of an adhesive for the purpose of creating a thin electrode. Examples of good vacuum deposition techniques include induction heating type vacuum deposition, resistance heating type vacuum deposition, laser beam type vacuum deposition, and electron beam type vacuum deposition, of which induction heating type vacuum deposition, resistance heating type vacuum deposition, and electron beam type vacuum deposition are used preferably because they can use a deposition source with a high heat output. The heat output of the deposition source must be sufficiently large to grow crystal grains large and dense in the aluminum metal layer 3, and accordingly, it is necessary for the base to have a sufficiently high surface temperature. However, it is difficult to directly measure it, and therefore, whether the heat quantity is sufficient or not is verified by determining whether the resulting aluminum metal layer 3 after the deposition step has the required properties.

When examining the crystal orientation in a cross section of the aluminum metal layer 3 in a photograph taken by the ACOM-TEM method, it is preferable for the aluminum metal layer to have a characteristic that the crystal regions oriented in any of <001>, <011>, and <111> directions account for 75% or less of the total area. It is also preferable that the surface of the aluminum metal layer that is not in contact with the resin film have a surface roughness Ra of 20 nm to 60 nm, that the aluminum metal layer have a thickness in the range of 0.5 $\mu$m to 3.0 $\mu$m, and that the average crystal size along the line that is parallel to the average line and is located at a depth of 300 nm from the top position of the outermost surface of the aluminum metal layer toward the resin film is 300 nm or less. However, when the heat output of the deposition source is raised to a required level, there is a possibility that the temperature of the resin film will increase to cause its melting if management of the cooling function is performed in the ordinary manner for the vacuum deposition method. Therefore, it is necessary to perform the deposition step while managing the cooling function so that the film is uniformly cooled while preventing the temperature from rising excessively. Specifically, it is necessary to cool the back face of the deposition surface uniformly by means of a cooling mechanism including a metal plate or metal roll that is sufficiently chilled by a refrigerant. To cool it uniformly, it is essential for the resin film and the cooling mechanism to be in close contact with each other without leaving a gap between them.

For example, if there are scratches on the metal roll of the cooling mechanism, the scratched area will form a gap and act to prevent effective cooling of the resin film in the scratched area, leading to its melting. For another example, if foreign matter gets between the resin film and the metal roll of the cooling mechanism, the resin film may not be cooled effectively due to the existence of the foreign matter, leading to its melting. As the heat output of the deposition source is raised to a required level, scratches on the metal roll or contamination with foreign matter that is normally tolerable in an ordinary vacuum deposition process can cause problems here, and therefore, stricter management of metal roll scratches and foreign matter contamination is needed. If the heat output of the deposition source is increased and the management of the cooling function is reinforced, it can serve for crystal grains to grow larger and denser in the aluminum metal layer 3, thereby reducing the internal resistance including contact resistance. In particular, the use of the electron beam deposition technique or the laser beam deposition technique is preferable because the heat output of the deposition source can be further enhanced when an alumina crucible, which has higher heat retention capability, is adopted instead of a carbon crucible.

In addition, it is preferable that the degree of vacuum during the metal deposition step be $9.0 \times 10^{-3}$ Pa or more and $1 \times 10^{-2}$ Pa or less. For the present invention, the surface irregularities should be controlled in the desirable surface roughness range. In particular, the surface irregularities in the metal film during the vacuum deposition step can be influenced significantly by the temperature of the base, which is the member being coated with metal, and the degree of vacuum during the vacuum deposition step. For the present invention, the surface roughness is controlled in the preferable range by increasing the temperature of the resin film 1, which is the member being coated with metal, to its maximum possible limit, and maintaining the degree of vacuum at $9.0 \times 10^{-3}$ Pa or more and $1 \times 10^{-2}$ Pa or less. Specifically, argon gas is introduced while air is aspirated by a vacuum pump, which serves to maintain the degree of vacuum at $9.0 \times 10^{-3}$ Pa or more, where large irregularities can develop easily in the metal surface. In addition, in order to maintain an appropriate rate of deposition of the metal film, the rate of introduction of argon gas is properly regulated so that the degree of vacuum is maintained at $1 \times 10^{-2}$ Pa or less.

<Resin film>

The resin film 1 used for the present invention is preferably a thin molded film of a polymer such as synthetic resin. It is also preferable to adopt a resin that is resistant to reactions with the electrolytic solution used in the intended secondary battery such as lithium-ion battery. Suitable resin films to use for the present invention include, for example, polyester films such as polyethylene terephthalate films and polyethylene naphthalate films among other polyester films, as well as polyimide films, polyphenylene sulfide films, and polypropylene films. In particular, the use of a polyethylene terephthalate film is more preferable. These resin films may be used singly or in combination. It may also be good to use a resin film having a surface coated with a resin, adhesive, or the like. Here, from the perspective of mechanical properties, thermal dimensional stability, and the like, it is preferable for the resin film to be a biaxially stretched film that has been stretched in two directions. The use of a uniaxially stretched film or an unstretched film is not preferable because dimensional changes can occur due to insufficient thermal dimensional stability or insufficient mechanical properties, which can lead to secondary batteries with poor safety or variations in battery capacity.

The thickness of the resin film 1 is preferably 1 μm or more and 20 μm or less, more preferably 3 μm or more and 10 μm or less, and particularly preferably 4 μm or more and 8 μm or less. For the purpose of providing a thin electrode base and accordingly providing an electrical storage element and an electrical storage element-containing electrical storage module that are smaller in size and weight and higher in energy density, the resin film is preferably as thin as possible and specifically, its thickness is preferably 20 μm or less, more preferably 10 μm or less, and particularly preferably 8 μm or less. However, if it is too thin, breakage or the like may occur during the production process to cause a decrease in yield, and accordingly, the thickness is preferably 1 μm or more, more preferably 3 μm or more, and particularly preferably 4 μm or more.

The surface roughness Ra of the resin film may be set arbitrarily, but if the surface is extremely smooth, problems such as poor conveyability and windability as well as reduced adhesion to the aluminum metal layer can arise and the resin film may also suffer blocking, i.e., sticking of the film to itself after winding. Conversely, if the surface roughness Ra is extremely large, although slipperiness and process suitability may improve, problems can occur during the formation of the aluminum metal layer, which is undesirable. For example, the aluminum metal layer can become coarse or suffer cracking easily, or good adhesion to the aluminum metal layer cannot be realized. Accordingly, the surface roughness Ra of the resin film surface is preferably 10 nm or more and 60 nm or less. Since it is preferable for the resin film to have only the minimum necessary roughness required for conveyance while being as smooth as possible, and accordingly, the surface roughness Ra is preferably 60 nm or less, and more preferably 50 nm or less.

<Anchor layer>

For the metalized film 4 for secondary battery positive electrodes according to the present invention, there may be an anchor layer 2 between the resin film and the aluminum metal layer 3. If such an anchor layer 2 is present, it can be expected to serve for improving the adhesion between the resin film and the aluminum metal layer. As the anchor layer 2, it is preferable to form a metal layer on the resin film by the sputtering method. The sputtering method can serve for forming a very thin anchor layer, and therefore, its use is highly suitable for the production of electrical storage batteries, which are required to be very thin.

The anchor layer 2 is preferably a metal layer containing at least one selected from the group consisting of aluminum, nickel, titanium, Nichrome, and chromium, but it is more preferable to adopt an aluminum metal layer formed by the sputtering method. It should be noted that it is important to ensure that the surface of the metal selected from aluminum, nickel, titanium, chromium, Nichrome, etc., for the anchor layer 2 is kept in an unoxidized state when the aluminum layer is formed on top of it. Specifically, after depositing a metal layer as the anchor layer 2 by sputtering, it is important not to expose it to the atmosphere but to maintain a vacuum while forming the aluminum metal layer 3. If the surface of the metal selected from aluminum, nickel, titanium, chromium, Nichrome, etc., for the anchor layer 2 is oxidized, a stable metal oxide film will be formed, making it difficult to develop metallic bonds at the interface with the aluminum metal layer 3 to be deposited subsequently. As a result, it will be impossible to secure sufficient adhesion, possibly leading to peeling of the aluminum metal layer 3 from the anchor layer 2. Therefore, it is important that the metal selected from aluminum, nickel, titanium, chromium, Nichrome, etc., for the anchor layer 2 is maintained in an unoxidized sate. If the anchor layer 2 is an aluminum metal layer formed by the sputtering method, it is preferable because subsequent vacuum deposition of the aluminum metal layer 3 on top of it will allow columnar crystals to grow even larger and denser, further suppressing the contact resistance in the aluminum metal layer.

The thickness of the anchor layer 2 is preferably 3 nm or more and 40 nm or less, and more preferably 5 nm or more and 20 nm or less. If its thickness is less than 3 nm, adequate adhesive strength will not be achieved in some cases. On the other hand, if the anchor layer has a thickness of more than 40 nm, it will not work effectively to further increase the adhesion, and therefore, it is preferably 40 nm or less. In the case where the anchor layer is formed by the sputtering method, which is relatively slow in depositing a film, it is even more preferable for the anchor layer to have a thickness of 20 nm or less to ensure higher productivity.

<Electrical storage element>

The electrical storage element according to the present invention includes an electrode assembly and a battery case for housing the electrode assembly. The electrode assembly includes a positive electrode, a negative electrode, and a separator interposed between the positive and the negative electrodes.

Examples of such an electrical storage element include primary batteries, secondary batteries, electrical double layer capacitors, and aluminum electrolytic capacitors, but for the present invention, the production of a secondary battery is intended.

Examples of secondary batteries include lithium secondary batteries, lead-acid batteries, nickel-cadmium batteries, nickel-hydrogen batteries, nickel-iron storage batteries, silver oxide-zinc storage batteries, manganese dioxide-lithium secondary batteries, lithium cobalt oxide-carbonate secondary batteries, and vanadium-lithium secondary batteries.

Among these, secondary batteries are preferable because they are expected to work over a long period of time, and lithium secondary batteries are more preferable because they employ organic solvents and can achieve high energy densities.

Examples of battery cases include aluminum cases, iron cases with nickel plated interior surfaces, and cases made of aluminum laminate films.

The shape of the battery case may be pouch-like, cylindrical, cuboid, and coin-like. Among these, the use of a pouch-like case is preferable because it can realize a high energy density, allows free design of shape, and is low in cost.

A positive electrode is formed by laminating a positive electrode material composed mainly of an active material, a binder resin, and a conductive additive onto a current collector. For the present invention, it is preferable to use a current collector.

Examples of useful active materials include lithium-containing transition metal oxides having layer-like structures such as $LiCoO_2$, $LiNiO_2$, and $Li(NiCoMn)O_2$, spinel type manganese oxides such as $LiMn_2O_4$, and iron based compounds such as $LiFePO_4$.

It is generally desirable to use a highly oxidation resistant resin as binder resin. Specific examples thereof include fluorine-containing resin, acrylic resin, and styrene-butadiene resin.

Useful conductive assistants include carbon materials such as carbon black and graphite.

For the positive electrode current collector, the use of metal foil is suitable, and the use of aluminum foil is particularly preferable.

The negative electrode is formed by laminating a negative electrode material composed mainly of an active material and a binder resin onto a current collector.

Examples of the active material include carbon materials such as artificial graphite, natural graphite, hard carbon, and soft carbon, lithium alloy-based materials of tin, silicon, etc., and metal materials such as lithium, and lithium titanate $(Li_4Ti_5O_{12})$.

Useful binder resins include fluorine-containing resin, acrylic resin, and styrene-butadiene resin.

For the negative electrode current collector, the use of metal foil is suitable, and the use of copper foil is particularly preferable.

The electrical storage element according to the present invention preferably includes an electrolytic solution. The electrolytic solution gives a space in which ions migrate between the positive electrode and the negative electrode in an electrochemical element such as secondary battery, and it consists mainly of an electrolyte substance dissolved in an organic solvent.

Examples of the electrolyte substance include $LiPF_6$, $LiBF_4$, and $LiClO_4$, of which $LiPF_6$ is generally used suitably from the viewpoint of solubility in organic solvents and ion conductance.

Examples of the organic solvent include ethylene carbonate, propylene carbonate, fluoroethylene carbonate, dimethyl carbonate, diethyl carbonate, and ethylmethyl carbonate, and these organic solvents may be used as a mixture of two or more thereof.

Described below is a method for producing a lithium secondary battery, which has been preferred among the various types of electrical storage elements.

As a method to produce a lithium secondary battery, first an active material and a conductive assistant are dispersed in a binder resin solution to prepare a coating solution for electrode formation and this coating solution is spread over a current collector, followed by drying to remove the solvent. A positive electrode and a negative electrode are formed in this way. After the drying step, the resulting coat film preferably has a thickness of 50 $\mu$m or more and 500 $\mu$m or less. Furthermore, it is preferable to apply pressure to the active material layer formed on the current collector by the roll-press method, for example, to make it denser and to reduce the thickness of the current collector.

A lithium secondary battery separator is interposed between the resulting positive electrode and negative electrode in such a manner that it comes in contact with the active material layer of each electrode, and then they are enclosed in a covering material such as aluminum laminate film. Subsequently, an electrolytic solution is injected, and a negative electrode lead, safety valve, etc. are attached, followed by sealing the covering material.

The secondary battery produced in this manner is characterized by strong adhesion to the electrodes, good battery properties, and low production cost.

<Electrical storage module>

Electrical storage elements produced by the aforementioned method or the like may be used to form an electrical storage module in which multiple electrical storage elements are connected in series to meet particular usage requirements of the electrical storage elements or required battery capacity. In such a case, the electrical storage elements are connected together with tab leads (current extraction lines), and housed in a module case made of resin or metal, thereby providing an electrical storage module.

EXAMPLES

The invention is described below with reference to examples. However, the present invention is not limited to these examples, and these examples may be modified or changed in accordance with the spirit of the invention. Such modifications and changes are not excluded from the scope of the present invention.

(Magnetron sputtering)

A resin film was placed in a batch type vacuum deposition apparatus (EBH-800, manufactured by ULVAC, Inc.), and a target with a size of 50 mm $\times$ 550 mm was used in an argon gas atmosphere, in which the ultimate degree of vacuum was adjusted to $5 \times 10^{-1}$ Pa or less. Then, power from a DC source was applied continuously for a duration required to achieve a specified metal film thickness.

Alternatively, a resin film was mounted in a roll type vacuum deposition apparatus (EWC-060, manufactured by ULVAC, Inc.), and a target with a size of 70 mm $\times$ 550 mm was used in an argon gas atmosphere, in which the ultimate degree of vacuum was adjusted to $1 \times 10^{-2}$ Pa or less. Then, power supplied from a pulsed power source was applied to form a metal layer.

Here, unless otherwise specified, sputtering and vacuum deposition were performed continuously while avoiding exposure to the atmosphere between the anchor layer and the aluminum metal layer.

(Vacuum deposition)

A resin film was put in a batch type vacuum deposition apparatus (EBH-800, manufactured by ULVAC, Inc.). An amount of aluminum required to achieve an intended thickness was placed on a deposition boat, and the apparatus was evacuated to an ultimate degree of vacuum of $9.0 \times 10^{-3}$ Pa or less. Then, the deposition boat was heated and vacuum deposition was performed, thereby forming an aluminum metal layer.

Alternatively, a resin film was put in a roll type vacuum deposition apparatus (EWC-060, manufactured by ULVAC, Inc.), and an appropriate transport speed and power output were set so as to form an aluminum metal layer on the mounted resin film to a prescribed thickness. Vacuum deposition was performed while heating an aluminum ingot by the induction heating type vacuum deposition method using a carbon crucible, thereby forming an aluminum metal layer.

Alternatively, a resin film was put in a roll type vacuum deposition apparatus (EWC-060, manufactured by ULVAC, Inc.), and a deposition boat was set to an appropriate transport speed and resistance heating conditions so as to form an aluminum metal layer with a prescribed thickness. Vacuum deposition was performed by feeding an aluminum wire to it, thereby forming an aluminum metal layer.

It should be noted that in any of these methods, the formation of an aluminum metal layer having a desired thickness in a single deposition run (where one run is defined as a set of unwinding, depositing, and winding steps) is preferable from the standpoint of productivity, resistance properties, quality, and grade. Alternatively, however, for example, a deposition run designed to perform thin film deposition for forming an aluminum metal layer with a thickness of 50 nm may be conducted 20 times repeatedly (repeating the aforementioned run 20 times) to form an aluminum metal layer with a total thickness of 1 $\mu$m.

(Regarding introduction of argon gas)

The argon gas introduction step uses the same argon gas as introduced in the magnetron sputtering step. In the batch type vacuum deposition apparatus (EBH-800, manufactured by ULVAC, Inc.), sputtering and vacuum deposition were not performed simultaneously, and therefore, argon gas introduction was not conducted in the vacuum deposition step.

In the roll type vacuum deposition apparatus (EWC-060, manufactured by ULVAC, Inc.), sputtering and vacuum deposition were performed successively. Accordingly, sputtering and vacuum deposition were performed simultaneously in the same deposition chamber, and argon gas was introduced constantly to the deposition source used for vacuum deposition.

(Processing of metalized film for secondary battery positive electrodes into secondary battery positive electrode)

Acetylene black graphite and polyvinylidene fluoride were added to lithium cobalt oxide (LiCoO$_2$) and dispersed in N-methyl-2-pyrrolidone to prepare slurry. This slurry was uniformly applied on one or both surfaces of the metalized film for secondary battery positive electrodes prepared in each Example or Comparative example, and then dried to prepare a positive electrode laminated layer. Subsequently, it was molded by pressing in a roll pressing machine to produce a band-shaped positive electrode in which the positive electrode layer, excluding the current collector, had a density of 3.6 g/cm$^3$.

(Aluminum crystal analysis by ACOM-TEM method)

This method provides a process designed to analyze the orientation distribution of a crystalline sample based on electron diffraction measured by TEM. An electron diffraction pattern is observed at different points by scanning the sample with an electron beam probe to provide crystal information with high spatial resolution. If this method is used, the method serves to capture information on smaller crystal grains compared to other methods such as SEM-EBSD. First, an ultrathin section for cross-sectional observation was prepared from the sample under examination by the FIB method (focused ion beam method, using Helios G4 facility, manufactured by Termo Fisher Scientific, Inc.).

Then, a TEM observation photograph of an ultrathin section (cross section) prepared by the pretreatment method described above was taken by using an electron microscope for atomic resolution analysis (JEM-ARM200F, manufactured by JEOL). Furthermore, in order to determine the crystal size and orientation, analysis of the aluminum metal layer was carried out by using ASTAR (manufactured by Nanomeans), and an ACOM-TEM analysis photograph was obtained using analysis software (OIM Analysis ver. 8, distributed by EDAX-TSL Solutions).

(Aluminum crystal size analysis by ACOM-TEM method)

For crystal size analysis, an ACOM-TEM analysis photograph was taken by the method described above, and the sizes (nm) of all aluminum crystals found along the line that is parallel to the outermost surface of the aluminum metal layer and is located at the position 300 nm away from the top position of outermost surface toward the resin film were measured. All measurements taken were added up and divided by the number of the crystals to calculate the average crystal size.

(Measurement of contact resistance)

The metalized film under examination was put on a 10 mm thick piece of NR sponge rubber (NRS-06, manufactured by Wakisangyo Co., Ltd.) with the metal film facing upward, and two 25 mm × 25 mm gold plated copper plates were placed on top of it with a 1 mm gap between them, followed by laying a 500 g weight on each copper plate. The resistance value between the two copper plates was measured using a resistance meter (RM3544, manufactured by Hioki E.E. Corporation), and the measurement was adopted as the contact resistance.

(Measurement of surface resistance)

The metalized film was cut into a piece with a size of approximately 300 mm × approximately 80 mm, and the surface resistance was measured by the four terminal method at three points using a quick type low-resistivity meter (Loresta (registered trademark) EP MCP-T360, manufactured by Mitsubishi Chemical Analytech Co., Ltd.). The average of the measured values was adopted as its surface resistance value.

(Thickness of aluminum metal layer)

An ultrathin section for cross-sectional observation was prepared by the FIB method from a metalized film sample. Then, a TEM observation photograph of an ultrathin section (cross section) prepared by the pretreatment method described above was taken by using an electron microscope for atomic resolution analysis (JEM-ARM200F, manufactured by JEOL). From this observation photograph, the distance between the resin film surface and the outermost surface of the aluminum metal layer was measured to determine the thickness of the aluminum metal layer.

(Surface roughness Ra)

The surface roughness Ra was measured under a scanning white light interferometly (manufactured by Hitachi High-Tech Science Corporation). The measurement was performed under the conditions of a measurement mode of "wave", a light source of 530 White, and a 50x objective lens, and calculations were made using the attached analysis software under the conditions of fourth-order surface correction, "full" interpolation, and a Gaussian filter for 2 $\mu$m cutoff.

(Evaluation of adhesion strength between resin film and aluminum metal layer)

A paper adhesive tape (No. 720, manufactured by NITTO) with a width of 18 mm was pasted to the surface of an aluminum metal layer. Subsequently, the paper adhesive tape was peeled off, and an evaluation was made based on whether the deposited film was separated from the resin film. The sample was rated as unacceptable (denoted by ×) when the deposited film was separated from the resin film and rated as acceptable (denoted by ∘) when such separation did not occur. This served as a criterion for determining whether the metalized film can be used for secondary battery positive electrodes.

(Evaluation of adhesion strength between aluminum metal layer and positive electrode active material layer)

A positive electrode active material was applied and pressed on a surface and a stainless steel plate was attached uniformly thereto using a piece of double sided tape (No. 5000NS, manufactured by NITTO) with a size of 1.5 cm × 8 cm and pressing it with a hand roller. Then, for peel test, using a Tensilon universal testing machine RTG-1210 (manufactured by AND), the specimen was peeled off at a 90-degree angle to the stainless steel plate at a speed of 200 mm/min. An evaluation was made based on whether the positive electrode active material was separated from the aluminum metal layer at the time of peeling. The sample was rated as unacceptable (denoted by ×) when the positive electrode active material was separated from the aluminum metal layer and rated as acceptable (denoted by ∘) when such separation did not occur. This served as a criterion for determining whether it was useful for secondary battery positive electrodes.

<Evaluation of use suitability>

According to the procedure described in each Example, a positive electrode active material was continuously applied to both surfaces of the metalized film for secondary battery positive electrodes prepared by the method described previously or to the surface of the aluminum metal layer that was not in contact with the resin film. After drying it by heating, it was processed by calender pressing to produce a positive electrode current collector. During this processing step, careful observation was made to see whether there occurred cissing (defect) in the coating step, or wrinkling, creasing, poor slipping, etc., in the conveyance or winding step. The sample was rated as acceptable (∘) in terms of use suitability when these drawbacks were not found and rated as unacceptable (×) in terms of use suitability when such a drawback was found.

(Example 1)

The resin film used was a biaxially oriented polyethylene terephthalate film with a thickness of 5.7 $\mu$m (Lumirror (registered trademark) Type F53, manufactured by Toray Industries, Inc.). This resin film had an average surface roughness Ra of 38 nm. A raw roll of this resin film was mounted in a roll type vacuum deposition apparatus (EWC-060, manufactured by ULVAC, Inc.), and aluminum was sputtered to a deposition thickness of 5 nm by applying electricity supplied from a pulsed power source. The deposition conditions used included a sputtering output of 2.0 kW generated by means of a pulsed power source. Then, vacuum deposition was performed while heating an aluminum ingot by the induction heating type vacuum deposition method using a carbon crucible, thereby depositing an aluminum metal layer with a thickness of 1.48 $\mu$m.

For the metalized film produced in this manner, an ACOM-TEM analysis of the aluminum metal layer was performed, and results showed that crystals oriented in the <001> direction accounted for a fraction of 0.184, crystals oriented in the <011> direction for a fraction of 0.221, and crystals oriented in the <111> direction for a fraction of 0.595. The surface of the aluminum metal layer that was not in contact with the resin film had a surface roughness Ra of 52 nm.

For this metal film, the surface of the aluminum metal layer that was not in contact with the resin film had a surface resistance value (A) of 0.037 $\Omega/\square$ and a contact resistance value (B) of 8.63 m$\Omega$, and the ratio of [contact resistance (B) / (surface resistance (A) $\times$ 1,000)], which represents the correlation between the contact resistance value and the surface resistance value, was 0.24.

The contact resistance value was not more than 15 m$\Omega$, and the contact resistance was sufficiently low. It was judged to be practically acceptable as an electrode current collector.

Furthermore, on the surface of the aluminum metal layer that was not in contact with the resin film, a positive electrode active material dispersion was prepared by mixing a ternary lithium-containing transition metal oxide Li(NiCoMn)O$_2$ (Ni/Co/Mn = 6/2/2), polyvinylidene difluoride (PVDF) as binder resin, and carbon black as conductive additive, and then adjusting the weight ratio among them to 94:3:3 by adding N-methylpyrrolidone as diluting solvent. This positive electrode active material dispersion was applied by a continuous roll-to-roll coating method using a coating machine equipped with a die coating head, followed by drying under heat and calender pressing while ensuring an electrode coating density of 2.8 g/cc. No coating defects or conveyance defects were seen during this processing step, and therefore, the sample was rated as acceptable "○" in terms of use suitability.

(Examples 2 to 4)

Except that the aluminum metal layer had a thickness as specified in Table 1, the same procedure as in Example 1 was carried out to produce a metalized film and evaluate it. Results are given in Table 1.

(Example 5)

The resin film used was a biaxially oriented polyethylene terephthalate film with a thickness of 5.7 $\mu$m (Lumirror (registered trademark) Type F53, manufactured by Toray Industries, Inc.). This resin film had a surface roughness Ra of 38 nm. A raw roll of this resin film was mounted in a roll type vacuum deposition apparatus (EWC-060, manufactured by ULVAC, Inc.), and vacuum deposition on the mounted resin film was carried out by adjusting the ultimate degree of vacuum to not more than 1 $\times$ 10$^{-2}$ Pa while introducing argon gas, and subsequently feeding an aluminum wire to the deposition boat, which was heated by resistance heating. Thus, an aluminum metal layer was deposited to a thickness of 1.04 $\mu$m, and its evaluation was made. Results are given in Table 1.

(Examples 6 and 7)

The resin film used was a biaxially oriented polyethylene terephthalate film with a thickness of 5.7 $\mu$m (Lumirror (registered trademark) Type F53, manufactured by Toray Industries, Inc.). This resin film had a surface roughness Ra of 38 nm. A raw roll of this resin film was mounted in a roll type vacuum deposition apparatus (EWC-060, manufactured by ULVAC, Inc.), and aluminum was sputtered on the mounted resin film to a deposition thickness of 5 nm by applying electricity supplied from a pulsed power source. The deposition conditions used included a sputtering output of 2.0 kW generated by means of a pulsed power source. Then, vacuum deposition was carried out by feeding an aluminum wire to the deposition boat, which was heated by resistance heating. Thus, an aluminum metal layer was deposited to a thickness of 1.02 $\mu$m or 0.78 $\mu$m, and its evaluation was made. Results are given in Table 1.

(Example 8)

The resin film used was a biaxially oriented polyethylene terephthalate film with a thickness of 5.7 $\mu$m (Lumirror (registered trademark) Type F53, manufactured by Toray Industries, Inc.). This resin film had a surface roughness Ra of 38 nm. This resin film was mounted in a batch type vacuum deposition apparatus (EBH-800, manufactured by ULVAC, Inc.), and aluminum was sputtered on the mounted resin film to a deposition thickness of 5 nm by applying electricity supplied from a pulsed power source. The deposition conditions used included a sputtering output of 2.0 kW generated by means of a pulsed power source. Then, vacuum deposition was carried out by the resistance heating type vacuum deposition method using a heated deposition boat, thereby depositing an aluminum metal layer to a thickness of 1.44 $\mu$m.

For the metalized film produced in this manner, an ACOM-TEM analysis of the aluminum metal layer was performed, and results showed that crystals oriented in the <001> direction accounted for a ratio of 0.715, crystals oriented in the <011> direction for a ratio of 0.105, and crystals oriented in the <111> direction for a ratio of 0.180. The surface of the aluminum metal layer that was not in contact with the resin film had a surface roughness Ra of 47 nm.

For this metal film, the surface of the aluminum metal layer that was not in contact with the resin film had a surface resistance value (A) of 0.038 Ω/□ and a contact resistance value (B) of 15.38 mΩ, and the ratio of [contact resistance (B) / (surface resistance (A) × 1,000)], which represents the correlation between the contact resistance value and the surface resistance value, was 0.41.

The contact resistance value was high, and the contact resistance was also relatively high in comparison with the surface resistivity, which correlates with the thickness of the aluminum metal layer. In addition, the ratio of [contact resistance (B) / (surface resistance (A) × 1,000)] is 0.41, which is larger in comparison with the metalized films described in Examples 1 to 7.

(Example 9)

Except that the aluminum metal layer had a thickness as specified in Table 1, the same procedure as in Example 8 was carried out to produce a metalized film and evaluate it. Results are given in Table 1.

(Example 10)

After forming a metalized film as in Example 6, an aluminum metal layer was also formed by the same procedure and under the same conditions as in Example 6 on the opposite surface of the resin film where no aluminum metal layer was present. Thus, the resulting resin film had aluminum metal layers on both surfaces thereof.

In addition, a positive electrode active material dispersion was applied on the aluminum metal layers laid on both surfaces of the resin film, followed by drying and roll pressing by the same procedure as in Example 1.

(Comparative example 1)

Except that the aluminum metal layer had a thickness as specified in Table 1, the same procedure as in Example 8 was carried out to produce a metalized film and evaluate it. Results are given in Table 1.

(Comparative examples 2 and 3)

The resin film used was a biaxially oriented polyethylene terephthalate film with a thickness of 5.7 μm (Lumirror (registered trademark) Type F53, manufactured by Toray Industries, Inc.). This resin film had a surface roughness of 38 nm. A raw roll of this resin film was mounted in a roll type vacuum deposition apparatus (EWC-060, manufactured by ULVAC, Inc.), and vacuum deposition on the mounted resin film was carried out by adjusting the ultimate degree of vacuum to not more than $1 \times 10^{-2}$ Pa and subsequently feeding an aluminum wire to the deposition boat, which was heated by resistance heating. Thus, an aluminum metal layer was deposited to a thickness of approximately 50 nm. This vacuum deposition run was repeated a total of 19 times in Comparative example 2 and a total of 8 times in Comparative example 3, and consequently, an aluminum metal layer was deposited to a thickness of 1.05 μm in Comparative example 2 and to a thickness of 0.41 μm in Comparative example 3, followed by evaluating them. Results are given in Table 1.

Among the various properties of the metal films, the interfacial adhesion strength between the resin film and the aluminum metal layer was so weak that the aluminum metal layer and the positive electrode active material partly peeled off together as a single unit from the resin film during the pressing step that was performed after the application of a positive electrode active material. Furthermore, the surface roughness Ra of the surface of the aluminum metal layer that was not in contact with the resin film was as small as 19 nm or 17 nm, resulting in a problem of wrinkling in some cases during the conveying step. In addition, the contact resistance was higher compared to the films obtained in Examples, and accordingly, it was judged overall that sufficient practicality was not achieved.

[Table 1-1]

[Table 1-1]

| | | deposition conditions | | | | adhesion strength at film/aluminum interface | aluminum metal layer thickness *Example 10 top face/ back face | resistance *Example 10 top face/back face | | |
|---|---|---|---|---|---|---|---|---|---|---|
| | heating method | deposition method (number of deposition runs) | Ar gas introduced during deposition O: present ×: absent | sputtered anchor ○: present ×: absent | degree of vacuum | peeling of tape ○: not peeled ×: peeled | | surface resistance (A) | contact resistance (B) | B/(A×1,000) |
| | | number | | | Pa | | μm | Ω/□ | mΩ | - |
| Example 1 | induction heating | 1 | ○ | ○ | 9.2×10⁻³ | ○ | 1.48 | 0.037 | 8.63 | 0.24 |
| Example 2 | induction heating | 1 | ○ | ○ | 9.4×10⁻³ | ○ | 1.06 | 0.051 | 9.58 | 0.19 |
| Example 3 | induction heating | 1 | ○ | ○ | 9.4×10⁻³ | ○ | 0.73 | 0.074 | 6.42 | 0.09 |
| Example 4 | induction heating | 1 | ○ | ○ | 9.6×10⁻³ | ○ | 0.53 | 0.102 | 14.84 | 0.15 |
| Example 5 | resistance heating | 1 | ○ | × | 9.5×10⁻³ | × | 1.04 | 0.048 | 11.70 | 0.25 |
| Example 6 | resistance heating | 1 | ○ | ○ | 9.1×10⁻³ | ○ | 1.02 | 0.050 | 10.30 | 0.21 |
| Example 7 | resistance heating | 1 | ○ | ○ | 9.3×10⁻³ | ○ | 0.78 | 0.070 | 6.25 | 0.09 |
| Example 8 | resistance heating | 1 | × | ○ | 9.3×10⁻³ | ○ | 1.44 | 0.038 | 15.38 | 0.41 |
| Example 9 | resistance heating | 1 | × | ○ | 9.5×10⁻³ | ○ | 0.94 | 0.055 | 24.89 | 0.46 |
| Example 10 | resistance heating | 2 | ○ | ○ | 9.1×10⁻³ | ○ | 1.02/1.05 | 0.050/0.049 | 10.30/10.22 | 0.21/0.21 |

16

EP 4 589 046 A1

| | | deposition conditions | | | | adhesion strength at film/aluminum interface | aluminum metal layer thickness *Example 10 top face/ back face | resistance *Example 10 top face/back face | | |
| --- | --- | --- | --- | --- | --- | --- | --- | --- | --- | --- |
| | heating method | deposition method (number of deposition runs) | Ar gas introduced during deposition O: present ×: absent | sputtered anchor ○: present ×: absent | degree of vacuum | peeling of tape ○: not peeled ×: peeled | | surface resistance (A) | contact resistance (B) | B/(A×1,000) |
| | | number | | | Pa | | μm | Ω/□ | mΩ | - |
| Comparative example 1 | resistance heating | 1 | × | ○ | $9.4 \times 10^{-3}$ | ○ | 0.80 | 0.064 | 29.31 | 0.46 |
| Comparative example 2 | resistance heating | 19 | × | × | $9.8 \times 10^{-3}$ | × | 1.05 | 0.052 | 36.23 | 0.70 |
| Comparative example 3 | resistance heating | 8 | × | × | $1.1 \times 10^{-2}$ | × | 0.41 | 0.120 | 51.35 | 0.43 |

[Table 1-2]

[Table 1-2]

| | crystal analysis data by ACOM-TEM *Example 10 top face/back face | | | | surface roughness of aluminum metal layer *Example 10 top face/back face | use suitability | adhesion strength at positive electrode active material/ aluminum interface | overall evaluation |
|---|---|---|---|---|---|---|---|---|
| | fraction of <001> oriented crystals | fraction of <011> oriented crystals | fraction of <111> oriented crystals | crystal size at 300 nm depth from outermost surface | Ra | coatability with positive electrode active material ○: good ×: inferior | peeling of tape ○: not peeled ×: peeled | good: ○ fair: △ inferior: × |
| | - | - | - | nm | nm | | | |
| Example 1 | 0.184 | 0.221 | 0.595 | 245 | 52 | ○ | ○ | ○ |
| Example 2 | 0.107 | 0.357 | 0.536 | 218 | 39 | ○ | ○ | ○ |
| Example 3 | 0.154 | 0.263 | 0.583 | 187 | 35 | ○ | ○ | ○ |
| Example 4 | 0.135 | 0.312 | 0.553 | 169 | 27 | ○ | ○ | ○ |
| Example 5 | 0.201 | 0.254 | 0.545 | 198 | 36 | ○ | ○ | △ |
| Example 6 | 0.119 | 0.217 | 0.664 | 216 | 34 | ○ | ○ | ○ |
| Example 7 | 0.132 | 0.225 | 0.643 | 179 | 31 | ○ | ○ | ○ |
| Example 8 | 0.715 | 0.105 | 0.180 | 128 | 47 | ○ | ○ | △ |
| Example 9 | 0.734 | 0.089 | 0.177 | 94 | 38 | ○ | ○ | △ |
| Example 10 | 0.119/0.135 | 0.217/0.229 | 0.664/0.636 | 216/225 | 34/38 | ○ | ○ | ○ |
| Comparative example 1 | 0.755 | 0.119 | 0.126 | 88 | 31 | ○ | ○ | × |
| Comparative example 2 | 0.858 | 0.069 | 0.073 | 345 | 19 | × | × | × |
| Comparative example 3 | 0.816 | 0.083 | 0.101 | 327 | 17 | × | × | × |

EXPLANATION OF NUMERALS

1. resin film
2. anchor layer
3. aluminum metal layer
4. metalized film

**Claims**

1. A metalized film for secondary battery positive electrodes comprising a resin film and an aluminum metal layer laid on at least one surface thereof, wherein the aluminum metal layer has a cross section **characterized by** having crystal orientation such that crystal regions oriented in any of <001>, <011>, and <111> directions account for not more than 75% of the total area as measured by the ACOM-TEM method.

2. A metalized film for secondary battery positive electrodes as set forth in claim 1, wherein the surface of the aluminum metal layer that is not in contact with the resin film has a surface roughness Ra of 15 to 60 nm.

3. A metalized film for secondary battery positive electrodes as set forth in claim 1, wherein the aluminum metal layer has a thickness of 0.5 to 3.0 $\mu$m.

4. A metalized film for secondary battery positive electrodes as set forth in claim 1, wherein the average crystal size along the line that is parallel to the average line and is located at a depth of 300 nm measured from the top position of the outermost surface of the aluminum metal layer toward the resin film is 300 nm or less.

5. A metalized film for secondary battery positive electrodes as set forth in claim 1, wherein the surface resistivity A ($\Omega/\square$) measured by the four terminal method on the aluminum metal layer and the contact resistance B (m$\Omega$) is within the range specified by the formula given below.

$$0.05 \leq B / (A \times 1,000) \leq 0.5$$

6. A method for producing a metalized film for secondary battery positive electrodes as set forth in claim 1 comprising a step for depositing vaporized aluminum to form a film on a resin film by means of a vacuum deposition process wherein an aluminum material serving as deposition source is heated and vaporized by at least one selected from the group consisting of resistance heating, induction heating, and electron beam heating while introducing argon gas during the process and wherein the degree of vacuum is maintained at $9.0 \times 10^{-3}$ Pa or more and $1 \times 10^{-2}$ Pa or less.

7. An electrical storage element comprising a metalized film for secondary battery positive electrodes as set forth in claim 1.

8. An electrical storage module comprising an electrical storage element as set forth in claim 7.

Figure 1

3

4

1

Figure 2

2

3

4

1

Figure 3

Figure 4

Figure 5

Figure 6

Figure 7

Figure 9

Aluminum film

Protective film (treatment film for observation)

Resin Film

0.5 μm

Figure 8

Aluminum film

Protective film (treatment film for observation)

Resin Film

0.5 μm

# Figure 10

# Figure 11

Figure 12

Figure 13

Figure 14

Figure 15

EP 4 589 046 A1

## INTERNATIONAL SEARCH REPORT

| | International application No. |
|---|---|
| | **PCT/JP2023/039052** |

### A. CLASSIFICATION OF SUBJECT MATTER

*C23C 14/14*(2006.01)i; *C23C 14/20*(2006.01)i; *H01M 4/64*(2006.01)i; *H01M 4/66*(2006.01)i
FI:   C23C14/14 B; H01M4/66 A; H01M4/64 A; C23C14/20 A

According to International Patent Classification (IPC) or to both national classification and IPC

### B. FIELDS SEARCHED

Minimum documentation searched (classification system followed by classification symbols)

C23C14/14; C23C14/20; H01M4/64; H01M4/66

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 05-320868 A (NISSIN ELECTRIC CO LTD) 07 December 1993 (1993-12-07)<br>entire text | 1-8 |
| A | WO 2015/033525 A1 (NEC CORPORATION) 12 March 2015 (2015-03-12)<br>entire text | 1-8 |
| A | JP 2007-299724 A (SONY CORP) 15 November 2007 (2007-11-15)<br>entire text | 1-8 |
| A | WO 2021/145344 A1 (FUJIFILM CORP) 22 July 2021 (2021-07-22)<br>entire text | 1-8 |
| A | CN 115161600 A (YANGZHOU NALI NEW MATERIAL TECHNOLOGY CO., LTD.) 11 October 2022 (2022-10-11)<br>entire text | 1-8 |
| A | JP 04-154958 A (KOBE STEEL LTD) 27 May 1992 (1992-05-27)<br>entire text | 1-8 |

[✓] Further documents are listed in the continuation of Box C.       [✓] See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **15 January 2024** | **23 January 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**

| International application No. |
| :--- |
| **PCT/JP2023/039052** |

**C.    DOCUMENTS CONSIDERED TO BE RELEVANT**

| Category* | Citation of document, with indication, where appropriate, of the relevant passages | Relevant to claim No. |
| :---: | :--- | :---: |
| P, A | WO 2022/244326 A1 (TORAY KP FILMS INC) 24 November 2022 (2022-11-24)<br>entire text | 1-8 |
| P, A | WO 2023/166633 A1 (TDK CORP) 07 September 2023 (2023-09-07)<br>entire text | 1-8 |

Form PCT/ISA/210 (second sheet) (July 2022)

**INTERNATIONAL SEARCH REPORT**
Information on patent family members

International application No.

**PCT/JP2023/039052**

| Patent document cited in search report | | | Publication date (day/month/year) | Patent family member(s) | | | Publication date (day/month/year) |
|---|---|---|---|---|---|---|---|
| JP | 05-320868 | A | 07 December 1993 | (Family: none) | | | |
| WO | 2015/033525 | A1 | 12 March 2015 | US | 2016/0211526 | A1 | |
| | | | | entire text | | | |
| JP | 2007-299724 | A | 15 November 2007 | (Family: none) | | | |
| WO | 2021/145344 | A1 | 22 July 2021 | US | 2022/0336820 | A1 | |
| | | | | entire text | | | |
| | | | | EP | 4092788 | A1 | |
| | | | | CN | 114830383 | A | |
| | | | | KR | 10-2022-0104781 | A | |
| CN | 115161600 | A | 11 October 2022 | (Family: none) | | | |
| JP | 04-154958 | A | 27 May 1992 | (Family: none) | | | |
| WO | 2022/244326 | A1 | 24 November 2022 | JP | 2022-188171 | A | |
| | | | | TW | 202302340 | A | |
| WO | 2023/166633 | A1 | 07 September 2023 | (Family: none) | | | |

Form PCT/ISA/210 (patent family annex) (July 2022)

32

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008160053 A
- JP HEI1040919 A

- JP 6211796 B